## Europäisches Patentamt
## European Patent Office
## Office européen des brevets

(19)

(11) Numéro de publication: **0 015 014**
**B1**

(12)

# FASCICULE DE BREVET EUROPEEN

(45) Date de publication du fascicule du brevet: **13.04.83**

(51) Int. Cl.³: **H 03 L 7/00, H 04 L 7/02**

(21) Numéro de dépôt: **80200078.6**

(22) Date de dépôt: **29.01.80**

(54) **Dispositif de resynchronisation rapide d'une horloge.**

(30) Priorité: **05.02.79 FR 7902902**

(43) Date de publication de la demande:
**03.09.80 Bulletin 80/18**

(45) Mention de la délivrance du brevet:
**13.04.83 Bulletin 83/15**

(84) Etats contractants désignés:
**DE FR GB SE**

(73) Titulaire: **TELECOMMUNICATIONS RADIOELECTRIQUES ET TELEPHONIQUES T. R. T. 88, rue Brillat Savarin F-75013 Paris (FR)**

(72) Inventeur: **Baudoux, Jean-Pierre SOCIETE CIVILE S.P.I.D. 209 rue de l'Université F-75007 Paris (FR)**

(74) Mandataire: **Tissot, Jean et al, Société Civile S.P.I.D. 209, rue de l'Université F-75007 Paris (FR)**

(56) Documents cités:
FR - A - 2 194 075
FR - A - 2 407 505
US - A - 3 164 777
US - A - 3 370 252
US - A - 3 696 422
US - A - 3 921 095
US - A - 3 983 498
US - A - 4 005 479

Courier Press, Leamington Spa, England.

Dispositif de resynchronisation rapide d'une horloge

L'invention concerne un dispositif de resynchronisation rapide d'une horloge sur une horloge externe, le générateur de l'horloge à synchroniser comprenant une boucle de verrouillage de phase fournissant l'horloge désirée par division de la fréquence d'une horloge de référence dans un diviseur de fréquence dont le facteur de division est commandé par un comparateur de phase qui détermine l'écart entre les transitions caractéristiques des deux horloges à synchroniser, une porte étant connectée entre le générateur de l'horloge de référence et l'entrée du diviseur de fréquence.

Un tel dispositif est utilisé par example dans le récepteur d'un système de transmission de données pour obtenir une horloge locale synchrone d'une horloge des données externe formée à partir du signal de données reçu. Il est important qu'au début de chaque transmission des données, à partir de l'instant où un circuit détecteur de signal a détecté l'apparition d'un signal de données à l'entrée du récepteur, la synchronisation de l'horloge locale sur l'horloge externe soit obtenue le plus rapidement possible.

Or, si aucune mesure n'est prise, cette resynchronisation risque d'être très lente avec le dispositif à boucle de verrouillage de phase tel qu'on l'a envisagé ci-dessus. Pour un récepteur d'un système de transmission de données, la fréquence des horloges à synchroniser est faible, par exemple 2400 Hz. L'horloge locale ayant cette fréquence est obtenue par division d'une fréquence de référence élevée fournie généralement par un oscillateur à quartz. Dans la boucle de verrouillage de phase, la correction de l'écart de phase détecté par le comparateur de phase est effectuée au rythme faible des horloges à synchroniser. La valeur de chaque correction (en avance ou en retard) est faible et correspond à une ou plusieurs périodes du signal de référence à fréquence élevée, afin de maintenir un synchronisme précis entre les deux horloges. Mais en contrepartie, le temps d'acquisition de la synchronisation peut être très long puisqu'au début de chaque transmission les deux horloges à synchroniser n'ont aucune relation de phase entre elles.

Pour acquérir rapidement la synchronisation, une technique connue, décrite par exemple dans le brevet américain n° 4 005 479 consiste à utiliser comme diviseur de fréquence, un compteur muni d'un accès pour sa remise à zéro. Ce compteur fournissant l'horloge locale est remis à zéro à l'instant d'apparition de la première transition caractéristique du signal de l'horloge externe. Cette remise à zéro fournit une transition caractéristique de l'horloge locale et à cet instant les deux horloges sont donc en phase; la boucle de verrouillage de phase agit ensuite normalement pour maintenir le synchronisme entre les deux horloges.

Toutefois, ce procédé de resynchronisation rapide n'est pas toujours applicable. Par exemple, dans les circuits intégrés réalisant la fonction de la boucle de verrouillage de phase, et comprenant notamment le compteur diviseur de fréquence, il n'existe aucun accès permettant la remise à zéro de ce compteur.

"On notera d'autre part que pour résoudre un problème de synchronisation différent, entre un générateur et un oscillateur de référence, le brevet américain n° 3 164 777 correspondant an priambule de la revendication 1 décrit un dispositif dans lequel, notamment, les oscillations de l'oscillateur de référence sont appliquées à un compteur-diviseur de fréquence à rapport de division variable par l'intermédiaire d'une porte qui est bloquée ou débloquée selon que la différence de phase entre le signal de sortie du diviseur de fréquence et un signal déduit dudit générateur, dépasse ou non un certain seuil.

La présente invention vise à fournir un autre moyen de resynchronisation rapide d'une horloge externe ne nécessitant pas d'accès particulier sur le compteur diviseur de fréquence et applicable notamment avec des boucles de verrouillage de phase réalisées en circuits intégrés.

Conformément à l'invention le dispositif de resynchronisation selon le priambule de la revendication est caractérisé en ce qu'il comporte des moyens pour bloquer cette porte après l'apparition successive d'un signal de commande de resynchronisation et de la prochaine transition caractéristique de l'horloge à synchroniser et des moyens pour débloquer cette porte à l'apparition de la prochaine transition caractéristique de l'horloge externe.

La description suivante en regard des dessins annexés, le tout donné à titre d'example, fera bien comprendre comment l'invention peut etre réalisée.

La figure 1 représente le schéma du dispositif de resynchronisation de l'invention.

La figure 2 montre des diagrammes de temps destines à en illustrer le fonctionnement.

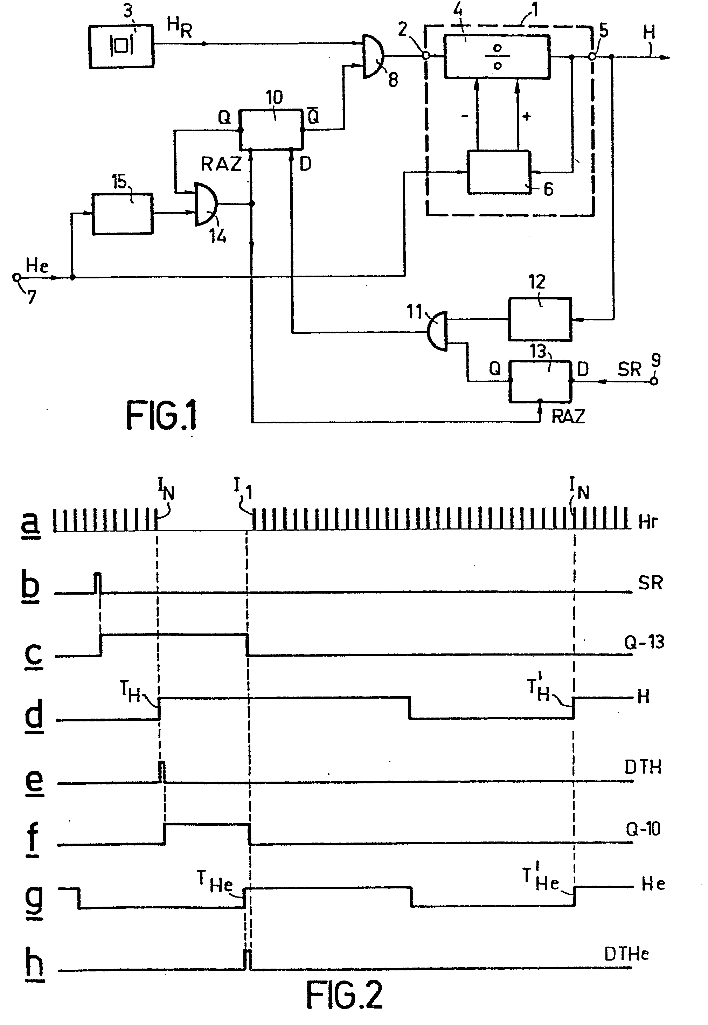

Le dispositif de l'invention représenté sur la figure 1 a pour but d'acquérir rapidement la synchronisation d'une horloge H sur une horloge externe He. Un montage bien connu pour obtenir une horloge H synchrone d'une horloge externe He, consiste à utiliser une boucle de verrouillage de phase 1 de type numérique, dont une entrée 2 reçoit directement une horloge de référence Hr fournie par un oscillateur à quartz 3 et ayant une fréquence élevée par rapport à celle des horloges à synchroniser. Dans la boucle de verrouillage de phase, la fréquence de l'horlage de référence Hr est appliquée à un diviseur de fréquence variable 4 fournissant l'horloge H à la sortie 5

2

de la boucle 1. La boucle de verrouillage de phase comporte un comparateur de phase 6 qui détermine, au rythme de l'horloge H, l'écart de phase entre les transitions caractéristiques du signal de l'horloge H et du signal de l'horloge externe He disponible sur la borne 7. Par exemple, le comparateur de phase 6 indique seulement le sens de cet écart de phase.

Le facteur de division du diviseur de fréquence 4 a normalement une valeur N permettant d'obtenir une fréquence d'horloge H égale ou très voisine de la fréquence nominale de l'horloge externe He. Quand le comparateur de phase 6 détecte une avance de phase des transitions du signal d'horloge H sur celles du signal d'horloge externe He, il fournit au diviseur de fréquence 4, via le fil repéré +, une impulsion de commande qui modifie son facteur de division de N en N+k de façon à réduire l'avance de phase détectée. Quand un retard de phase est détecté, le comparateur de phase fournit au diviseur de fréquence, via le fil repéré —, une impulsion de commande qui modifie son facteur de division de N en N—k de façon à réduire le retard de phase détecté. Le diviseur de fréquence 4 est un compteur binaire ayant par exemple un modulo N fixe et qui produit, en l'absence des impulsions de commande précitées, un facteur de division de fréquence égal à N. Les facteurs de division N+k et N—k sont obtenus, au moyen de ces impulsions de commande en supprimant ou en ajoutant k impulsions de la fréquence de l'horloge de référence Hr à l'entrée de ce compteur binaire.

La mise en phase des transitions du signal de l'horloge H sur celles du signal de l'horloge externe He s'effectue ainsi en corrigeant les écarts de phase détectés par des incréments kT, T étant le période de l'horloge de référence Hr. Pour maintenir, en régime, un synchronisme précis entre les deux horloges H et He, les incréments kT doivent avoir une valeur faible par rapport à la valeur élevée de le période des horloges H et He. Mais il en résulte que le temps d'acquisition de la synchronisation peut être très long, si l'écart de phase entre les deux horloges à synchroniser est important.

Un moyen connu pour obtenir dans ce cas une resynchronisation rapide de l'horloge H sur l'horloge externe He, consiste à remettre à zéro le compteur binaire constituant le diviseur à fréquence 4 juste à l'instant où apparaît la première transition caractéristique de l'horloge externe qui suit l'apparition d'un signal de commande de resynchronisation. Cette remise à zéro produit une transition caractéristique de l'horloge H qui se trouve donc en phase avec celle de l'horloge externe He. La boucle de verrouillage en phase permet ensuite de maintenir un synchronisme précis, comme on l'a expliqué. Mais ce procédé n'est pas toujours applicable. Par example dans les ciccuits intégrés du commerce réalisant la fonction de la boucle de verrouillage de phase 1, on n'a pas d'accès pour effectuer la remise à zéro du diviseur variable 4.

La présente invention fournit un autre moyen de resynchronisation rapide de deux horloges, permettant notamment d'éviter cette difficulté.

Conformément à l'invention, la fréquence de l'horloge de référence Hr est appliquée à l'entrée 2 de la boucle de verrouillage de phase 1 par l'intermédiaire d'une porte 8, des moyens étant prévus pour bloquer cette porte 8 par la transition caractéristique de l'horloge H qui suit l'apparition sur la borne 9 d'un signal de commande de resynchronisation, et pour débloquer ensuite la porte 8 par une transition caractéristique de l'horloge externe He.

Dans l'exemple de la figure 1, on utilise pour bloquer ou débloquer la porte 8 une bascule 10 de type D dont la sortie $\overline{Q}$ est reliée à une entrée de la porte 8. Cette bascule 10 est commandée à l'état Q=1 par une impulsion apparaissant à son entrée D et produite à le sortie de la porte 11. Le détecteur de transition 12 fournit une impulsion à chaque transition caractéristique du signal de l'horloge à synchroniser H, mais ces impulsions ne sont transmises par la porte 11 vers l'entrée D de la bascule 10 que si la bascule 13 est à l'état Q=1. Cet état Q=1 de la bascule 13 est obtenu quand à son entrée D se produit une impulsion du signal de commande de synchronisation SR. Par ailleurs, lorsque la bascule 10 est à l'état Q=1, elle peut être remise à zéro par une impulsion apparaissant sur son entrée RAZ et produite à la sortie de la porte 14. Le détecteur de transition 15 produit une impulsion à chaque transition caractéristique du signal de l'horloge externe He, mais ces impulsions ne sont transmises par la porte 14 pour remettre à zéro la bascule 10, que si cette dernière est effectivement à l'état Q=1. Les impulsions transmises par la porte 14 sont appliquées également à l'entrée RAZ de la bascule 13 pout la remettre à zéro.

Le fonctionnement du dispositif de resynchronisation que l'on vient de décrire est illustré par les diagrammes de la figure 2. Le diagramme 2a représente les impulsions du signal de l'horloge de référence Hr, qui sont transmises par la porte 8 et comptées dans le diviseur de fréquence 4, les transitions supprimées par la porte 8 et donc non comptées, n'apparaissant pas. Pour la clarté du diagramme, on n'a pas représenté toutes les impulsions Hr, de sorte qu'elles apparaissent avec une fréquence relativement faible. Au début du diagramme les bascules 10 et 13 sont à l'état Q=0 comme le représentent respectivement les diagrammes 2f et 2c, et le compteur 4 compte les impulsions de l'horloge Hr transmises par le porte 8. Le diagramme 2b montre une impulsion du signal de commande de resynchronisation SR qui apparaît sur la borne 9. Le flanc descendant de cette impulsion SR fait basculer à l'état Q=1 la bascule 13 (voir diagramme 2c). L'impulsion $I_N$ de l'horloge de référence Hr est la dernière impulsion du cycle de comptage du diviseur de fréquence 4. Cette impulsion $I_N$ remet automatiquement à zéro ce diviseur de fréquence, ce qui produit la transition caractéristique $T_H$ du signal de l'horloge à synchroniser H, comme le montre le diagramme 2*d*. Cette transition $T_H$ produit dans le signal de sortie DTH du détecteur de transition 12 une impulsion brève (montrée sur le diagramme 2*e*) qui est transmise, via la porte 11 alors passante, à l'entrée D de la bascule 10. Le flanc descendant de cette impulsion DTH fait basculer la bascule 10 à l'état Q=1 (voir diagramme 2*f*). Il en résulte que la porte 8 ne transmet plus les impulsions de l'horloge de référence Hr et que le diviseur de fréquence 4 reste à l'état zéro. Lorsqu'apparaît une transition caractéristique $T_{He}$ du signal de l'horloge externe He montrée sur le diagramme 2*g*, il se produit dans le signal de sortie DTHe du détecteur de transition 15 une impulsion brève (montrée sur le diagramme 2*h*) qui est transmise, via la porte 14 alors passante aux entrées RAZ des bascules 10 et 13. Le flanc descendant de cette impulsion DTHe remet à zéro ces bascules. La porte 8 transmet alors de nouveau les impulsions de l'horloge de référence Hr vers le diviseur de fréquence 4. Ce dernier compte alors normalement N impulsions allent de $I_1$ à $I_N$ et cette impulsion $I_N$ produit une nouvelle transition caractérisstique $T'_H$ du signal de l'horloge H, qui se produit sensiblement au même instant que la transition caractéristique $T'_{He}$ du signal de l'horloge externe, puisque ces deux horloges H et He ont sensiblement la même fréquence. Puisque la bascule 13 a été remise à zéro, la transition $T'_H$ et les transitions caractéristiques suivantes du signal de l'horloge H ne sont pas détectées par le détecteur 12, la porte 8 reste passante et la boucle de verrouillage de phase 1 assure normalement sa fonction de correction des faibles écarts de phase entre les transitions caractéristiques des deux signaux d'horloge H et He. Si pour une raison quelconque, il se produit une perte de synchronisme entre les deux horloges, une resynchronisation rapide peut être effectuée en appliquant sur la borne 9 une impulsion de commande de resynchronisation.

## Revendications

1. Dispositif de resynchronisation rapide d'une horloge (H) sur une horloge externe (He), le générateur de l'horloge à synchroniser (H) comprenant une boucle de verrouillage de phase (1) fournissant l'horloge désirée (H) par division de la fréquence d'une horloge de référence ($H_R$) dans un diviseur de fréquence (4) dont le facteur de division est commandé par un comparateur de phase qui détermine l'écart entre les transitions $(T'_H)$, $(T'_{He})$ caractéristiques des deux horloges à synchroniser, une porte (8) étant connectée entre le générateur (3) de l'horloge de référence ($H_R$) et l'entrée (2) du diviseur de fréquence (4), caractérisé en ce qu'il comporte des moyens (10), (11), (12), (13) pour bloquer cette porte (8) après l'apparition successive d'un signal de commande de resynchronisation ($S_R$) et de la prochaine transition caractéristique ($T_H$) de l'horloge à synchroniser et des moyens (10), (14), (15) pour débloquer cette porte (8) à l'apparition de la prochaine transition caractéristique ($T_{He}$) de l'horloge externe.

2. Dispositif selon la revendication 1, caractérisé en ce qu'il comporte une première bascule (10) pour bloquer ou débloquer ladite porte (8), une deuxième bascule (13) pour enregistrer le signal de commande de resynchronisation ($S_R$), un premier détecteur de transition (12) pour former des impulsions correspondant auxdites transitions caractéristiques ($T_H$) de l'horloge à synchroniser, ces impulsions n'étant transmises vers la première bascule (10) pour commander le blocage de ladite porte (8) que lorsque la deuxième bascule (13) a enregistré un signal de commande de resynchronisation ($S_R$), enfin un deuxième détecteur de transition (15) pour former des impulsions correspondant auxdites transitions caractéristiques ($T_{He}$) de l'horloge externe, ces impulsions étant transmises vers les première et deuxième bascules (10), (13) pour les remettre à zéro.

## Patentansprüche

1. Schaltungsanordnung zur schnellen Synchronisierung eines Taktimpulssignals (H) mit einem äusseren Taktimpulssignal (He) wobei der Generator des zu synchronisierenden Taktimpulssignales (H) eine phasenverregelte Schleife (1) aufweist, die das gewünschte Taktimpulssignal (H) durch Teilung der Frequenz eines Bezugstaktimpulssignals ($H_R$) in einem Frequenzteiler (4) liefert, dessen Teilungsfaktor durch eine Phasenvergleichsanordnung gesteuert wird, die die Abweichung zwischen den Übergängen in derselben Richtung $(T'_H)$, $(T'_{He})$ bestimmt, die charakteristisch sind für die zwei zu synchronisierenden Taktimpulssignale, wobei zwischen dem Taktimpulsgenerator (3) des Bezugssignals ($H_R$) und dem Eingang (2) der Frequenzteilerschaltung (4) eine Torschaltung (8) vorgesehen ist, dadurch gekennzeichnet, dass die Schaltungsanordnung Mittel (10, 11, 12, 13) enthält zum Sperren dieser Torschaltung (8) nach dem sukzessiven Auftritt eines Synchronisierungsregelsignals ($S_R$) und des nächsten charakteristischen Überganges ($T_H$) des zu synchronisierenden Taktimpulssignals und Mittel (10, 14, 15) zum Freigeben dieser Torschaltung (8) beim Auftritt des nächstfolgenden charakteristischen Überganges ($T_{He}$) des äusseren Taktimpulssignals.

2. Schaltungsanordnung nach Anspruch 1, dadurch gekennzeichnet, dass diese eine erste bistabile Kippschaltung (10) aufweist zum Sperren oder Freigeben der genannten Torschaltung (8), eine zweite bistabile Kippschaltung (13) zum Speichern des Synchronisierungsregelsignals ($S_R$), einen ersten Übergangsdetetor (12) zum Erzeugen von Impulsen, die den genannten charakteristischen Übergängen $(T_h)$ des zu synchronisierenden Taktimpulssignals entsprechen, wobei diese Impulse der ersten bistabilen Kippschaltung (10) zum Sperren der genannten Torschaltung (8) erst dann zugeführt werden, wenn die zweite bistabile Kippschaltung (13) ein Resynchronisierungsregelsignal $(S_R)$ empfangen hat, und einen zweiten Übergangsdetektor (15) zum Bilden von Impulsen entsprechend den charakteristischen Übergängen des äusseren Taktimpulssignals $(T_{He})$, wobei diese Impulse den ersten und den zweiten bistabilen Kippschaltungen (10, 13) zugeführt werden um diese auf Null rückzustellen.

## Claims

1. A circuit for rapidly resynchronizing a clock (H) with an external clock (He), the generator of the clock (H) to be synchronized comprising a phase-locked loop (1) supplying the desired clock (H) by dividing the frequency of a reference clock $(H_R)$ in a frequency divider (4), the division factor of which is controlled by a phase comparator detecting the deviation between the transitions in the same sense $(T'_H)$, $(T'_{He})$ which are characteristic of the two clocks to be synchronized, a gate (8) being interconnected between the generator (3) generating the reference clock $(H_R)$ and the input (2) of the frequency divider (4), characterized in that the circuit comprises means (10), (11), (12), (13) for rendering this gate (8) nonconductive after the successive appearance of a resynchronizing control signal $(S_R)$ and the next characteristic transition $(T_H)$ of the clock to be synchronized, and means (10), (14), (15 for rendering this gate (8) conductive at the appearance of the following characteristic transition $(T_{He})$ of the external clock.

2. A circuit as claimed in Claim 1, characterized in that it comprises a first bistable trigger circuit (10) for rendering said gate (8) non-conductive or conductive, a second bistable trigger circuit (13) for storing the resynchronizing control signal $(S_R)$, a first transition detector (12) for forming the pulses corresponding to the said characteristic transitions $(T_H)$ of the clock to be synchronized, these pulses not being transmitted to the first bistable trigger circuit (10) to control cut-off of the said gate (8) until the second bistable trigger circuit (13) has received a resynchronizing control signal $(S_R)$, and a second transition detector (15 for forming the pulses corresponding to the characteristic transitions of the external clock $(T_{He})$, these pulses being transmitted to the first and the second bistable trigger circuits (10), (13) to reset them to zero.

FIG.1

FIG.2